# EUROPEAN PATENT APPLICATION

(11) **EP 2 172 965 A1**
(43) Date of publication of application: **07.04.2010**
(21) Application number: 08777560.7
(22) Date of filing: 24.06.2008
(51) Int. Cl.: H01L 21/027, G01M 11/02, G03F 1/08, G03F 7/20

(54) **OPTICAL CHARACTERISTIC MEASUREMENT METHOD, OPTICAL CHARACTERISTIC ADJUSTING METHOD, EXPOSURE DEVICE, EXPOSURE METHOD, AND EXPOSURE DEVICE MANUFACTURING METHOD**

(30) Priority: 26.06.2007 JP 2007168021
(71) Applicant: Nikon Corporation, Chiyoda-ku Tokyo 100-8331 (JP)
(72) Inventor: TOYAMA, Kiyoshi, Tokyo 100-8331 (JP); NAKAMURA, Ayako, Tokyo 100-8331 (JP)
(74) Representative: Hooiveld, Arjen Jan Winfried
(86) International application number: PCT/JP2008/061495
(87) International publication number: WO 2009/001834

(57) **Abstract**

There is provided an optical characteristic measuring method for measuring an optical characteristic of an optical system which forms, on a second plane, an image of an object arranged on a first plane, the optical characteristic measuring method including: an arranging step (S20) of arranging at least one phase pattern on the first plane; an illuminating step (S22) of illuminating the phase pattern, arranged in the arranging step, with a light having a predetermined wavelength; an extracting step (S23, S25) of extracting a partial image of a pattern image formed via the phase pattern and the optical system; and a detecting step (S24, S26) of detecting information about the light in relation to the partial image extracted in the extracting step.

## Description

### TECHNICAL FIELD

The present invention relates to an optical characteristic measuring method for measuring an optical characteristic of an optical system usable to produce an electronic device including, for example, semiconductor elements, liquid crystal display elements, etc. in the lithography step; an optical characteristic adjusting method for adjusting the optical characteristic of the optical system; an exposure apparatus provided with the optical system; an exposure method using the exposure apparatus; and an exposure apparatus producing method for producing the exposure apparatus.

### BACKGROUND ART

For example, when a semiconductor element or a liquid crystal display element, etc. is produced, an exposure apparatus is used to expose a substrate (a glass plate, a semiconductor wafer, etc.) coated with a resist via an optical system (projection optical system) with a pattern formed on a mask (a reticle, a photomask, etc.). It is necessary for the exposure apparatus to project the pattern formed on the mask onto the substrate at a high resolution. Therefore, the optical system, which is provided on the exposure apparatus, is designed to have satisfactory optical characteristics in which various aberrations are sufficiently corrected.

However, it is difficult to produce the optical system as exactly as designed. The optical system, which is actually produced, has any optical characteristic which is different from the designed optical characteristic in some cases. Therefore, it is necessary that the optical characteristic of the produced optical system should be measured to adjust the optical characteristic of the optical system based on an obtained measurement result. For example, Japanese Patent Application Laid-open No. 2000-77295 describes a technique for measuring an optical characteristic of an optical system, wherein a spatial image of a phase pattern formed via the optical system is detected at a plurality of defocus positions to measure and determine the optical characteristic of the optical system based on the change of the intensity distribution of the detected spatial image of the phase pattern.

### DISCLOSURE OF THE INVENTION

In accordance with the progress of fine and minute mask patterns, it becomes necessary that the optical characteristic of the optical system provided on the exposure apparatus should be measured more highly accurately. In such a situation, it is conceived that the intensity distribution of the spatial image of the phase pattern is obtained by directly detecting the spatial image of the phase pattern formed via the optical system by, for example, a sensor such as CCD or the like. However, in this case, it is necessary that the sensor has a spatial resolution required to detect the intensity distribution of the spatial image of the phase pattern. That is, it is necessary that the pixels of the sensor such as CCD or the like is sufficiently small-sized depending on the spatial resolution. However, at present, any sensor, which satisfies this requirement, does not exist. Therefore, it has been difficult to measure the optical characteristic of the optical system more highly accurately.

Another method is also known, in which a magnifying optical system is arranged on the side of a light-incident surface of the sensor in order to obtain a necessary spatial resolution by the sensor such as CCD or the like. However, a problem arises such that the measuring system is large-sized due to the arrangement of the magnifying optical system.

An object of the present invention is to provide an optical characteristic measuring method which makes it possible to measure an optical characteristic of an optical system highly accurately, an optical characteristic adjusting method which makes it possible to adjust the optical characteristic of the optical system highly accurately, an exposure apparatus which is provided with the optical system, an exposure method using the exposure apparatus, and an exposure apparatus producing method for producing the exposure apparatus.

According to the present invention, there is provided an optical characteristic measuring method for measuring an optical characteristic of an optical system which forms, on a second plane, an image of an object arranged on a first plane, the optical characteristic measuring method characterized by comprising: an arranging step of arranging at least one phase pattern on the first plane; an illuminating step of illuminating the phase pattern, arranged in the arranging step, with a light having a predetermined wavelength; an extracting step of extracting a partial image of a pattern image formed via the phase pattern and the optical system; and a detecting step of detecting information about the light in relation to the partial image extracted in the extracting step.

According to the present invention, there is provided an optical characteristic adjusting method characterized by comprising a measuring step of measuring an optical characteristic of an optical system in accordance with the optical characteristic measuring method of the present invention; and an adjusting step of adjusting the optical characteristic of the optical system by using a measurement result obtained in the measuring step.

According to the present invention, there is provided an exposure apparatus which forms a pattern of a mask on a photosensitive substrate, the exposure apparatus characterized by comprising an optical system which is adjusted in accordance with the optical characteristic adjusting method of the present invention.

According to the present invention, there is provided an exposure apparatus which forms a pattern of a mask via an optical system on a photosensitive substrate, the exposure apparatus characterized by comprising: an extracting section which extracts an image of a part of a pattern image formed via the optical system and a phase pattern arranged on one of an object plane and an image plane of the optical system; and a detecting section which detects information about a light in relation to the image of the part extracted by the extracting section.

According to the present invention, there is provided an exposure method for forming a pattern of a mask on a photosensitive substrate, the exposure method characterized by comprising: an illuminating step of illuminating the pattern; and an exposure step of forming an image of the pattern, illuminated in the illuminating step, on the photosensitive substrate by an optical system adjusted in accordance with the optical characteristic adjusting method of the present invention.

According to the present invention, there is provided an exposure apparatus producing method for producing an exposure apparatus which forms a pattern of a mask via an optical system on a photosensitive substrate, the exposure apparatus producing method characterized by comprising: an adjusting step of adjusting an optical characteristic of the optical system in accordance with the optical characteristic adjusting method of the present invention; and an installing step of installing, in the exposure apparatus, the optical system adjusted in the adjusting step.

According to the present invention, there is provided an exposure apparatus producing method for producing an exposure apparatus which forms a pattern of a mask via an optical system on a photosensitive substrate, the exposure apparatus producing method characterized by comprising: an installing step of installing the optical system in the exposure apparatus; and an adjusting step of adjusting an optical characteristic of the optical system, installed in the installing step, in accordance with the optical characteristic adjusting method of the present invention.

According to the optical characteristic measuring method of the present invention, the partial image of the pattern image formed via the phase pattern and the optical system is extracted to detect the information about the light (light beam) in relation to the extracted partial image. Therefore, the optical characteristic of the optical system can be measured highly accurately.

According to the optical characteristic adjusting method of the present invention, the optical characteristic of the optical system is measured in accordance with the optical characteristic measuring method of the present invention, and the optical characteristic of the optical system is adjusted by using the obtained measurement result. Therefore, it is possible to obtain the optical system having the satisfactory optical characteristic.

According to the exposure apparatus of the present invention, the exposure apparatus is provided with the optical system adjusted in accordance with the optical characteristic adjusting method of the present invention. Therefore, the image of the pattern of the mask can be formed on the photosensitive substrate at a high resolution via the optical system having the satisfactory optical characteristic.

According to the exposure apparatus of the present invention, the exposure apparatus is provided with the extracting section which extracts the image of the part of the pattern image formed via the optical system and the phase pattern arranged on one of the object plane and the image plane of the optical system, and the detecting section which detects the information about the light in relation to the image of the part extracted by the extracting section. Therefore, the optical characteristic of the optical system can be measured highly accurately. Therefore, the image of the pattern of the mask can be formed on the photosensitive substrate at a high resolution via the optical system having the satisfactory optical characteristic.

According to the exposure method of the present invention, the pattern of the mask can be formed on the photosensitive substrate at a high resolution by the optical system adjusted in accordance with the optical characteristic adjusting method of the present invention.

According to the exposure apparatus producing method of the present invention, the optical characteristic of the optical system is adjusted in accordance with the optical characteristic adjusting method of the present invention, and the adjusted optical system is installed in or provided in the exposure apparatus. Alternatively, the optical system is installed in the exposure apparatus, and the optical characteristic is adjusted for the optical system, installed in the exposure apparatus, in accordance with the optical characteristic adjusting method of the present invention. Therefore, it is possible to produce the exposure apparatus provided with the optical system having the satisfactory optical characteristic.

### BRIEF DESCRIPTION OF THE DRAWINGS

Fig. 1 shows a schematic construction of a projection exposure apparatus according to an embodiment.
Fig. 2 shows a flow chart for illustrating a method for producing the projection exposure apparatus according to the embodiment.
Fig. 3 shows a flow chart for illustrating a method for measuring the optical characteristic of the projection optical system according to the embodiment.
Fig. 4 shows a construction of a measuring mask according to the embodiment.
Fig. 5 shows a plan view of a construction of a measuring device according to the embodiment.
Fig. 6 shows a sectional view of the construction of the measuring device according to the embodiment.
Fig. 7 shows a graph illustrating an intensity distribution of a phase pattern image in a case that the defocus amount of a projection optical system is zero.
Fig. 8 shows graphs illustrating intensity distributions of the phase pattern image in a case that the defocus amount of a projection optical system is not zero.
Fig. 9 shows a graph illustrating a relationship between the focus amount of the projection optical system and the difference in light amount between lights passing through an area in which the phase pattern is advanced and an area in which the phase pattern is delayed.
Fig. 10 shows a construction of another measuring mask according to the embodiment.
Fig. 11 shows a construction of the measuring mask according to the embodiment.
Fig. 12 shows a construction of another measuring device according to the embodiment.
Fig. 13 shows a construction of another light-receiving pattern according to the embodiment.
Fig. 14 shows a construction of another phase pattern according to the embodiment.
Fig. 15 shows a flow chart illustrating a method for producing a semiconductor device as a microdevice according to the embodiment.

### BEST MODE FOR CARRYING OUT THE INVENTION

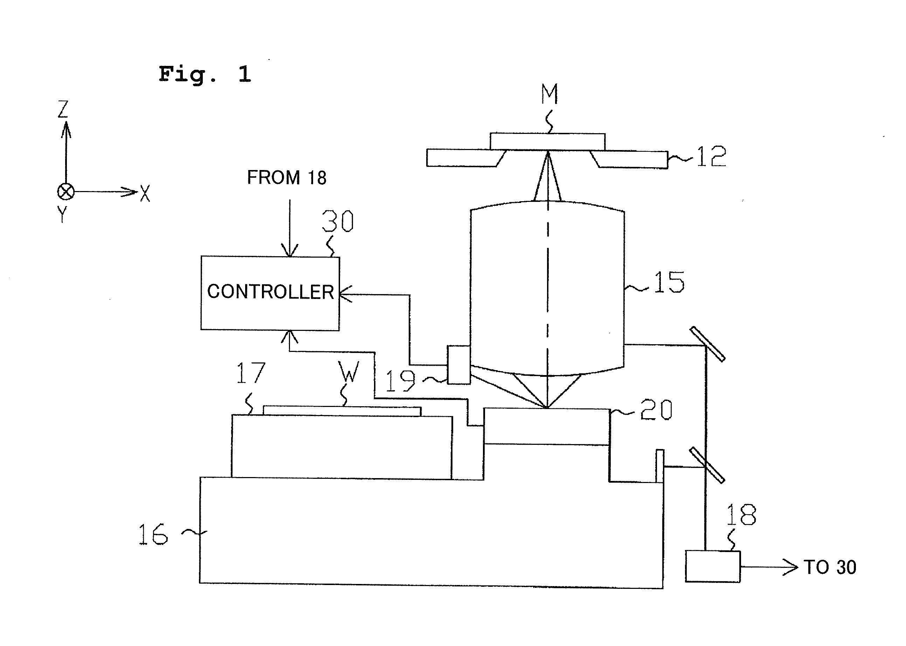

A projection exposure apparatus (exposure apparatus) according to an embodiment will be explained below with reference to the drawings. Fig. 1 shows a schematic construction of the projection exposure apparatus according to this embodiment.

In the following description, an XYZ rectangular coordinate system is set as shown in each of the drawings. An explanation will be made about the positional relationship of respective members with reference to the XYZ rectangular coordinate system. The XYZ rectangular coordinate system is set so that the X axis and the Y axis are parallel to a wafer (photosensitive substrate) W, and the Z axis is set in a direction perpendicular to the wafer W. It is assumed that the X axis extends in a direction parallel to the sheet surface of Fig. 1, and the Y axis extends in a direction perpendicular to the sheet surface of Fig. 1.

The projection exposure apparatus shown in Fig. 1 includes a light source (not shown) which supplies an exposure light (exposure light beam), an illumination optical system (not shown) which uniformly illuminates a mask M with the light (light beam) from the light source, and a projection optical system (optical system) 15 which images a pattern formed on the mask M on the wafer W. The projection exposure apparatus further includes a mask stage 12 which holds the mask M and which is capable of adjusting the position of the pattern formation surface of the mask M with respect to the object plane of the projection optical system 15 (plane parallel to the XY plane), and a wafer stage 16 which holds the wafer W and which is capable of adjusting the position of a surface of the wafer W with respect to the image plane of the projection optical system 15 (plane parallel to the XY plane).
The embodiment of the present invention is explained as exemplified by the wafer W as the substrate by way of example. However, the substrate is not limited to the wafer W, and may be a glass plate.

The light, which exits from the light source, illuminates the mask M via the illumination optical system at a uniform illuminance in a superimposed or overlay manner. Those usable as the light source include light sources of the mercury lamp, the KrF excimer laser, the ArF excimer laser, the F₂ laser, the extreme ultraviolet light, etc.

The light, via or passing through the mask M, comes into the projection optical system 15. The projection optical system 15 is constructed of a plurality of optical members. The projection optical system 15 images the pattern formed on the mask M at a predetermined magnification (reducing magnification, 1X magnification, or magnifying magnification) on the wafer W. The wafer stage 16, which holds the wafer W, is constructed of an XY stage which is movable in the directions of the X axis and the Y axis, a Z stage which is movable in the direction of the Z axis and which is inclinable with respect to the Z axis, etc. The Z stage of the wafer stage 16 is provided with a wafer holder 17 which attracts and holds the wafer W. Respective exposure areas, which are formed on the wafer W, are successively exposed with the pattern of the mask M while the wafer stage 16 is two-dimensionally driven and controlled in the XY plane. The projection exposure apparatus is provided with a wafer stage interferometer 18 which measures the position in the XY plane on the wafer W, and an autofocus system 19 which measures the position of the wafer W in the Z direction. Measurement results obtained by the wafer stage interferometer 18 and the autofocus system 19 are outputted to a controller 30.

The projection exposure apparatus is provided with a measuring device 20 which measures the optical characteristic of the projection optical system 15. The construction of the measuring device 20 will be described later on. A measurement result obtained by the measuring device 20 is outputted to the controller 30.

The controller 30 adjusts the optical characteristic of the projection optical system 15 based on the measurement result outputted from the measuring device 20. A measuring method and an adjusting method for the optical characteristic of the projection optical system 15 will be described and explained in detail later on.

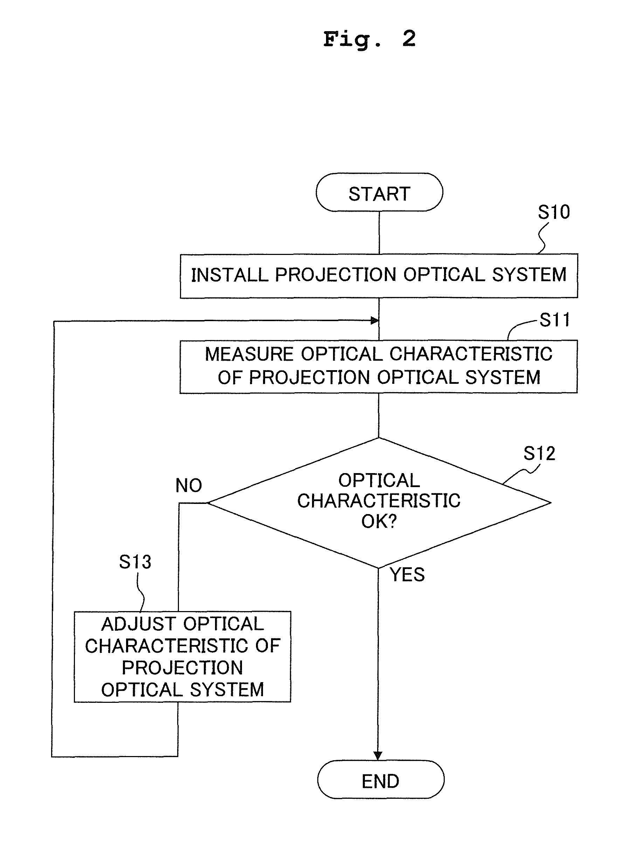

Next, an explanation will be made about a method for producing the projection exposure apparatus (exposure apparatus) according to this embodiment with reference to a flow chart shown in Fig. 2.

At first, the projection optical system 15 is designed so that various aberrations are sufficiently corrected to provide satisfactory optical characteristics. The projection optical system 15, which is produced after the design, is installed or arranged in the projection exposure apparatus at a predetermined position (Step S10, installing step). Subsequently, the optical characteristic is measured for the projection optical system 15 installed in the projection exposure apparatus in Step S10 (Step S11). That is, various aberrations, which result from a variety of factors, remain in some cases in the actually produced projection optical system. Therefore, the optical characteristic of the projection optical system is measured. It is judged whether or not the optical characteristic of the projection optical system 15 is satisfactory based on the measurement result (Step S12). If the optical characteristic of the projection optical system 15 is not satisfactory, the optical characteristic of the projection optical system 15 is adjusted (Step S13, adjusting step). The routine returns to Step S11 to measure the optical characteristic of the projection optical system 15 again. On the other hand, if the optical characteristic of the projection optical system 15 is satisfactory, the production of the projection exposure apparatus is completed.

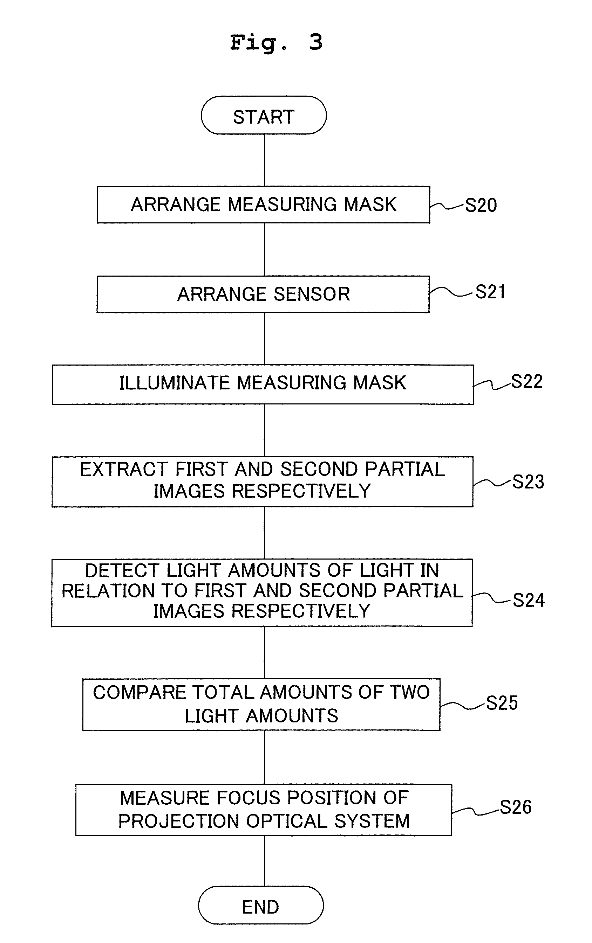

Fig. 3 shows a flow chart for illustrating the method for measuring the optical characteristic of the projection optical system (optical system) 15 according to this embodiment (measuring step in Step S11 shown in Fig. 2). Here, the optical characteristic of the projection optical system 15 according to this embodiment includes the aberration (aberration represented by the focus and the spherical aberration) which is symmetrical with respect to the optical axis of the projection optical system 15 in relation to the measuring direction of the optical characteristic. In this embodiment, an explanation will be made as exemplified by the measurement of the focus position of the projection optical system 15 by way of example.

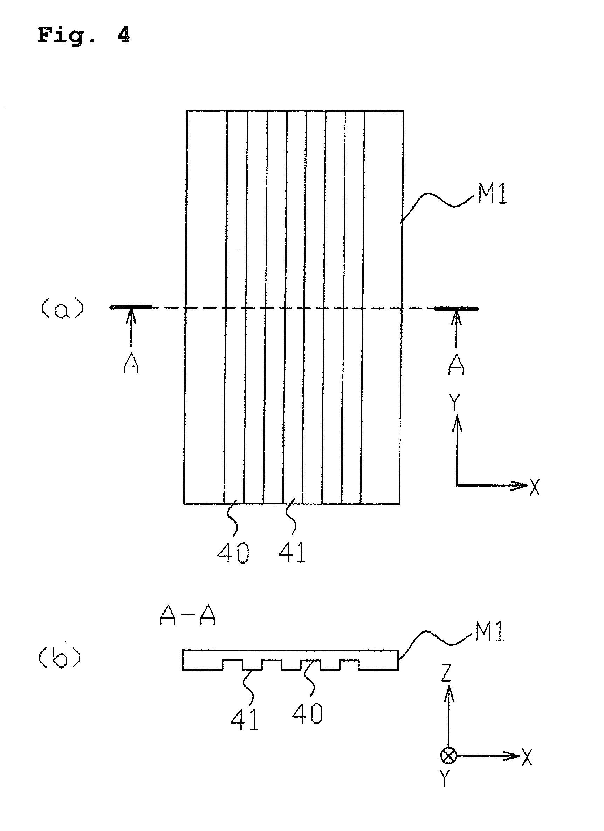

At first, a measuring mask, on which a phase pattern is formed, is arranged on the mask stage 12 (Step S20, arranging step). Fig. 4(a) shows a plan view of a construction of the measuring mask M1. Fig. 4(b) shows a sectional view taken along a line A-A. As shown in Figs. 4(a) and 4(b), the measuring mask M1 is formed with a line-and-space transmission type phase pattern (diffraction grating) composed of recesses 40 and protrusions 41 each of which has a width of several hundreds nm in the measuring direction (X direction). In this construction, the phase difference θ of the phase pattern is the phase difference of θ = nλ/4 (n = ±1, ±3, ±5,...) or in the vicinity thereof provided that λ represents the center wavelength of the light used for the measurement. This embodiment is constructed so that the phases of the light passing through the recesses 40 and the protrusions 41 are shifted or moved by 90°. The recesses 40 and the protrusions 41 may be constructed so that the phases of the light passing therethrough are shifted or moved by 270°, without being limited to 90°.

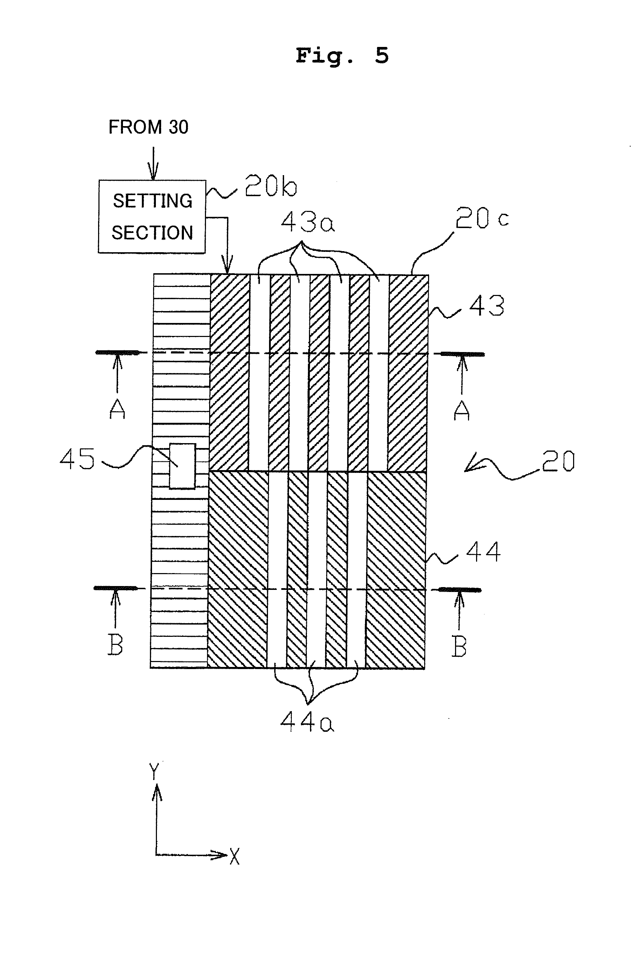

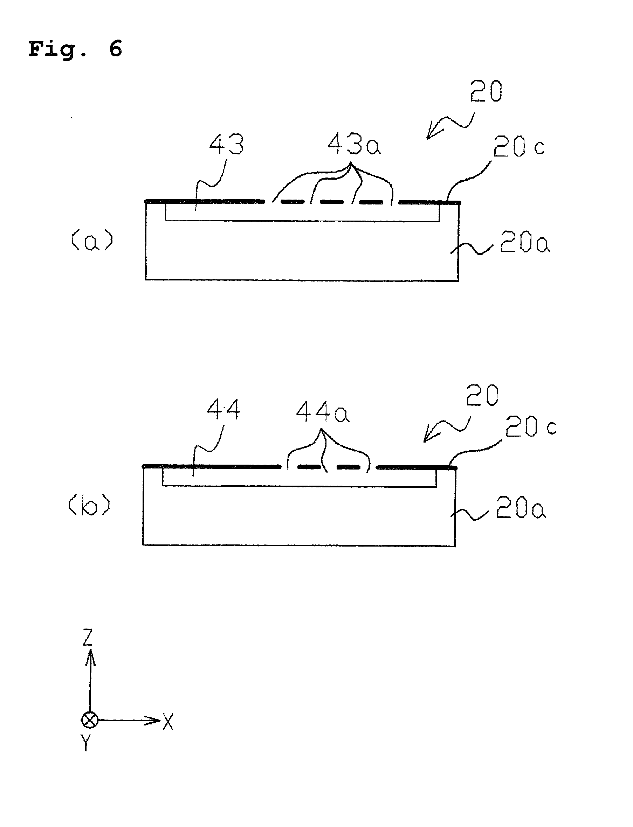

Subsequently, the measuring device 20 is arranged in the projection area (field) of the projection optical system 15 by moving the wafer stage 16 in the XY directions (Step S21). Fig. 5 shows a plan view of a construction of the measuring device 20, Fig. 6(a) shows a sectional view taken along a line A-A shown in Fig. 5, and Fig. 6(b) shows a sectional view taken along a line B-B shown in Fig. 5. As shown in Figs. 5, 6(a), and 6(b), the measuring device 20 is provided with a pattern plate 20C which is formed with light-receiving patterns 43a, 44a as the extracting section, and a sensor section 20a (for example, CCD or a light amount detection sensor, etc.) which functions as the detecting section for receiving the light passing through the light-receiving patterns. With reference to Fig. 1, the measuring device 20 is installed or arranged in the vicinity of the wafer holder 17 on the wafer stage 16. The pattern formation surface of the pattern plate 20C is set to have an approximately same height as that of the surface of the wafer W. The pattern plate 20C has an area 43 which has the first light-receiving pattern 43a and an area 44 which has the second light-receiving pattern 44a. Only the light, which is transmitted through the recesses 40 of the phase pattern via the projection optical system 15, passes through the first light-receiving pattern 43a. Only the light, which is transmitted through the protrusions 41 of the phase pattern via the projection optical system 15, passes through the second light-receiving pattern 44a. The pattern plate 20C may be provided with a boundary area between the first light-receiving pattern 43a and the second light-receiving pattern 44a.

The sensor section 20a, which is provided on the measuring device 20, is connected to a setting section 20b which sets a light-receiving area corresponding to the first light-receiving pattern 43a, a light-receiving area corresponding to the second light-receiving pattern 44a, and a light-receiving area corresponding to a reference aperture 45 in order to independently receive the light passing through the first light-receiving pattern 43a, the light passing through the second light-receiving pattern 44a, and the light passing through the reference aperture 45 as described later on respectively. The sensor section 20a detects the light passing through the first light-receiving pattern 43a and the light passing through the second light-receiving pattern 44a independently respectively by the setting section 20b. That is, the first light-receiving pattern 43a and the second light-receiving pattern 44a selectively extract, from the phase pattern image, a part of the phase pattern image (partial image) having a first intensity corresponding to an area in which the phase of the phase pattern is relatively advanced and a part of the phase pattern image (partial image) having a second intensity corresponding to an area in which the phase of the phase pattern is relatively delayed. The operation of the setting section 20b is controlled by the controller 30.

Upon measuring the optical characteristic, the measurement accuracy is affected in some cases by the light amount change of illumination light (illumination light beam). Accordingly, in this embodiment, the pattern plate 20C is formed with the reference aperture 45 in order to monitor the light amount change of the illumination light. In a case that the light amount change of the illumination light is monitored, the setting section 20b sets the light-receiving area corresponding to the reference aperture 45 to detect the light passing through the reference aperture 45. The light amount of the light passing through the reference aperture 45 is monitored, and the measurement result of the optical characteristic of the projection optical system 15 is corrected based on the monitoring result. Accordingly, it is possible to maintain the high measurement accuracy.

Subsequently, the measuring mask, which is arranged in Step S21, is illuminated with a light (light beam) having a predetermined wavelength, i.e., a measuring light (measuring light beam) having a same wavelength as that of the light (light beam) used for the exposure (Step S22, illuminating step). The images of the phase pattern are formed on the areas 43, 44 of the measuring device 20 via the phase pattern and the projection optical system 15.

Subsequently, the first light-receiving pattern 43a is used to extract a part of the phase pattern image (hereinafter referred to as "first partial image") having the first intensity corresponding to the recesses 40 of the phase pattern, and the second light-receiving pattern 44a is used to extract a part of the phase pattern image (hereinafter referred to as "second partial image") having the second intensity corresponding to the protrusions 41 of the phase pattern (Step S23, extracting step).

Subsequently, the total amount or sum total I1 (first information about the light) of the light amounts of the light in relation to the first partial image and the total amount or sum total I2 (second information about the light) of the light amounts of the light in relation to the second partial image extracted in step S23 are detected respectively (Step S24, detecting step). Specifically, the light-receiving areas of the sensor section 20a are set so that each of the light transmitted through the first light-receiving pattern 43a and the light transmitted through the second light-receiving pattern 44a is detected by the sensor section 20a with the setting section 20b. The total amounts I1, I2 of the light amounts detected by the sensor section 20a are outputted to the controller 30.

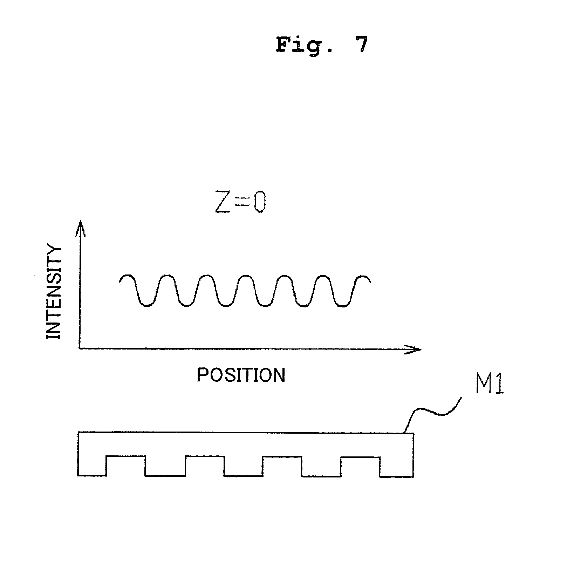

Subsequently, the total amount I1 and the total amount I2 of the light amounts, which are detected in Step S24, are compared with each other (Step S25), and the focus position of the projection optical system 15 is measured by using a result of the comparison performed in Step S25 (Step S26, measuring step). In this procedure, if the projection optical system 15 involves no focus deviation (in the case of the defocus amount Z = 0), the intensity of the light transmitted through the recesses 40 of the phase pattern is identical with the intensity of the light transmitted through the protrusions 41 of the phase pattern as shown in a graph in Fig. 7. Therefore, the total amount I1 of the light amounts of the light received via the first light-receiving pattern 43a is equal to the total amount I2 of the light amounts of the light received via the second light-receiving pattern 44a. The difference between the light amounts ΔI is ΔI = I1 - I2 = 0.

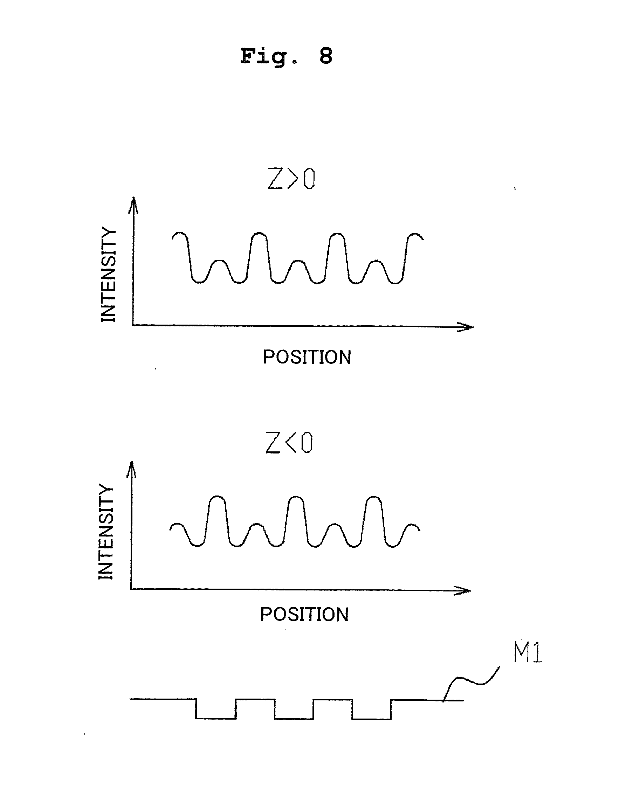

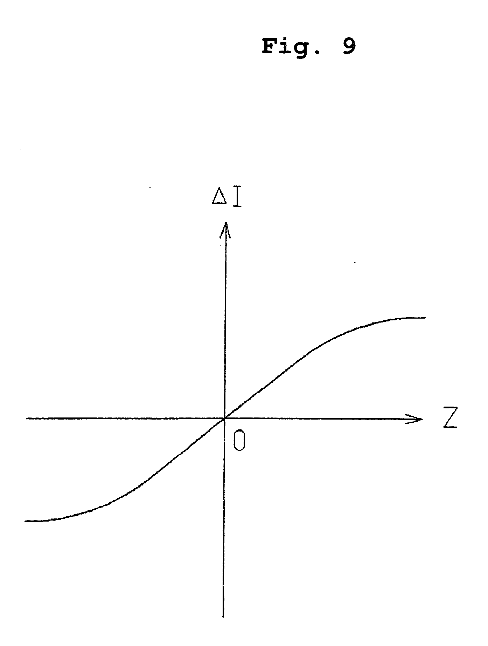

On the other hand, if the projection optical system 15 involves any focus deviation (in the case of Z > 0 or Z < 0), the intensity of the light transmitted through the recesses 40 of the phase pattern is different from the intensity of the light transmitted through the protrusions 41 of the phase pattern as shown in graphs in Fig. 8. Therefore, the total amount I1 of the light amounts of the light received via the first light-receiving pattern 43a is different from the total amount I2 of the light amounts of the light received via the second light-receiving pattern 44a. Therefore, the difference between the light amounts ΔI is ΔI = I1 - I2 ≠ 0. As shown in Fig. 9, the relationship between Z and ΔI is a sin function. In a case that the defocus amount (amount of Z) is small, Z and ΔI can be regarded to be in a relationship of direct proportion. Therefore, the focus position of the projection optical system 15 can be measured highly accurately by determining ΔI.

The adjustment of the focus position of the projection optical system 15 (adjusting step in Step S13), which is based on the result measured in Step S11 in the flow chart shown in Fig. 2, is executed by calculating the adjustment amount for the focus position based on the measurement result so that the focus position of the projection optical system 15 is adjusted. Specifically, the focus position is adjusted by using an optical member (for example, wedge-shaped pair glass members) constructing the projection optical system 15. In a case that the focus position is adjusted by using the wedge-shaped pair glass members, it is appropriate that the pair glass members are rotated relative to each other. The focus position may be also adjusted by moving the Z stage in the optical axis direction of the projection optical system 15.

According to the projection exposure apparatus concerning this embodiment, the light-receiving patterns 43a, 44a, which are provided on the measuring device 20, are used to selectively extract the part of the phase pattern image (partial image) having the intensity corresponding to the area in which the phase of the phase pattern is relatively advanced, from the phase pattern image formed via the projection optical system 15 and the part of the phase pattern image (partial image) having the intensity corresponding to the area in which the phase of the phase pattern is relatively delayed, from the phase pattern image. The optical characteristic of the projection optical system 15 can be measured highly accurately based on the light amounts of the light in relation to the respective partial images extracted by the sensor section 20a. Further, the optical characteristic of the projection optical system 15 can be adjusted by using the obtained measurement result; and it is possible to obtain the projection optical system 15 having the satisfactory optical characteristic. Therefore, the pattern image of the mask M can be formed at a high resolution on the wafer W via the projection optical system 15 having the satisfactory optical characteristic.

According to the method for measuring the optical characteristic concerning this embodiment, the part of the phase pattern image (partial image) having the intensity corresponding to the area in which the phase of the phase pattern is relatively advanced is selectively extracted from the phase pattern image, and the part of the phase pattern image (partial image) having the intensity corresponding to the area in which the phase of the phase pattern is relatively delayed is selectively extracted from the phase pattern image to detect the light amounts of the light in relation to the respective extracted partial images. Therefore, although the recesses 40 and the protrusions 41 of the phase pattern having the high spatial resolution are used, it is possible to receive the light by the sensor such as CCD or the like having a rough spatial resolution. Therefore, the required measured value can be correctly detected; and it is possible to highly accurately measure the optical characteristic (focus position) of the projection optical system 15.

According to the method for adjusting the optical characteristic concerning this embodiment, the optical characteristic of the projection optical system 15 is measured, and the optical characteristic of the projection optical system 15 is adjusted by using the obtained measurement result. Therefore, it is possible to obtain the optical system having the satisfactory optical characteristic in which the aberration is sufficiently corrected.

According to the method for producing the projection exposure apparatus concerning this embodiment, the optical characteristic of the projection optical system 15 is measured and adjusted in accordance with the method for measuring the optical characteristic and the method for adjusting the optical characteristic concerning this embodiment. Therefore, it is possible to produce the exposure apparatus provided with the projection optical system having the satisfactory optical characteristic in which the aberration is sufficiently corrected.

In the method for measuring the optical characteristic according to this embodiment, the focus position of the projection optical system 15 is measured by using the phase pattern as shown in Fig. 4 and the light-receiving pattern as shown in Figs. 5 and 6. However, it is also allowable that a measuring mask, which is formed with two or more phase patterns having identical shapes, is used. In this case, it is allowable to install or provide, to or on the measuring device, a pattern plate provided with two or more light-receiving patterns in conformity with the number of phase patterns. In the construction as described above, the focus position of the projection optical system 15 can be measured at a plurality of image heights in the projection area of the projection optical system 15.

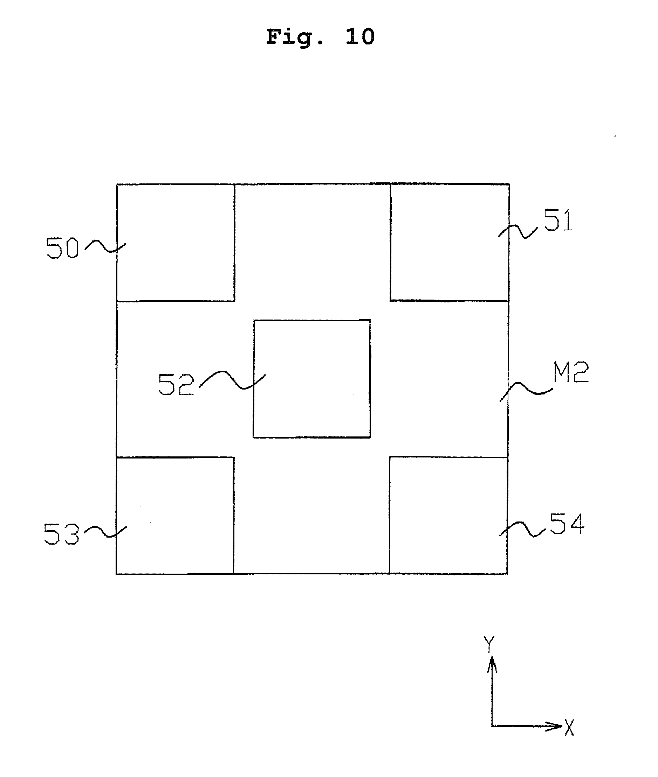

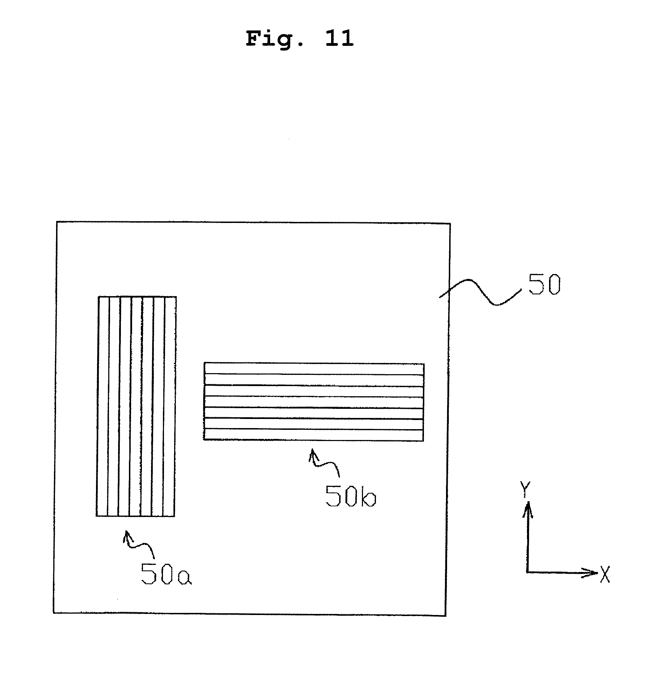

Fig. 10 shows a construction of a measuring mask M2 formed with five phase patterns. As shown in Fig. 10, the measuring mask M2 is formed with phase pattern areas 50 to 54 for performing the measurement at five points having different image heights in the projection area of the projection optical system 15. Fig. 11 shows a construction of the phase pattern area 50. The phase pattern areas 51 to 54 are constructed in the same manner as the phase pattern area 50. As shown in Fig. 11, two phase patterns, which are of mutually different types, are formed in the phase pattern area 50. In this embodiment, a first phase pattern 50a and a second phase pattern 50b, which are perpendicular to each other, are formed as the two phase patterns of the different types. Each of the two phase patterns 50a, 50b is formed of a transmission type line-and-space pattern composed of recesses and protrusions each having a width of several hundreds nm.

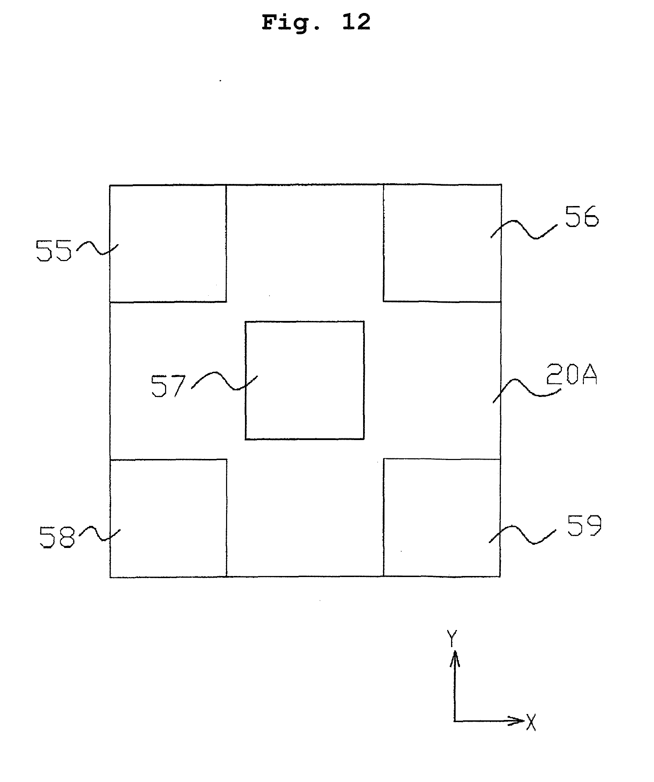

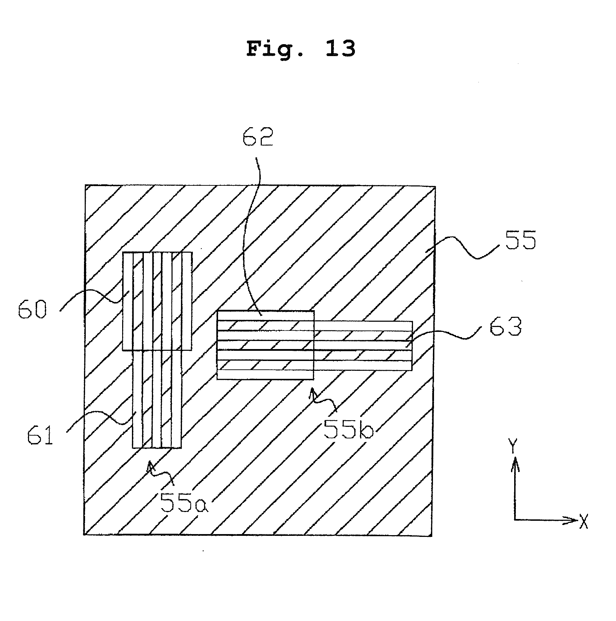

Fig. 12 shows a pattern plate 20A of the measuring device usable in a case that the optical characteristic of the projection optical system 15 is measured by using the measuring mask M2 shown in Fig. 10. As shown in Fig. 12, pattern areas 55 to 59, which correspond to the phase pattern areas 50 to 54, are formed on the upper surface of the pattern plate 20A. Fig. 13 shows a construction of the pattern area 55. The pattern areas 56 to 59 are constructed in the same manner as the pattern area 55. As shown in Fig. 13, the pattern area 55 has a first light-receiving section or receiving portion 55a which receives the light transmitted through the phase pattern 50a via the projection optical system 15 and a second light-receiving section or receiving portion 55b which receives the light transmitted through the phase pattern 50b via the projection optical system 15. The first light-receiving section 55a has a first light-receiving pattern 60 and a second light-receiving pattern 61. Only the light, which is transmitted through the recesses of the phase pattern 50a, passes through the first light-receiving pattern 60, and only the light, which is transmitted through the protrusions of the phase pattern 50a, passes through the second light-receiving pattern 61. The second light-receiving section 55b has a first light-receiving pattern 62 and a second light-receiving pattern 63. Only the light, which is transmitted through the recesses of the phase pattern 50b, passes through the first light-receiving pattern 62, and only the light, which is transmitted through the protrusions of the phase pattern 50b, passes through the second light-receiving pattern 63.

The measuring device 20 is connected to an unillustrated setting section which sets the light-receiving areas of the sensor section so that the lights, which pass through the first light-receiving pattern 60 or the second light-receiving pattern 61 of the first light-receiving section 55a and the first light-receiving pattern 62 or the second light-receiving pattern 63 of the second light-receiving section 55b respectively, are detected individually (independently). The lights, each of which passes through one of the first light-receiving pattern 60 and the second light-receiving pattern 61 of the first light-receiving section 55a and the first light-receiving pattern 62 and the second light-receiving pattern 63 of the second light-receiving section 55b, can be detected distinctly respectively in accordance with the setting effected by the setting section. One or more reference aperture or reference apertures may be provided on the light-receiving pattern of the pattern plate 20A. For example, the reference aperture may be provided on each of the light-receiving pattern areas 55 to 59.

In a case that the information about the light in relation to the image of the phase pattern is detected by using the measuring mask M2 and the pattern plate 20A, the image of the phase pattern can be simultaneously measured at a plurality of image heights in the projection area of the projection optical system 15. Therefore, it is possible to measure the optical characteristic of the projection optical system 15 quickly and highly accurately. The optical characteristic of the projection optical system 15, which includes the curvature of image or the field curvature, etc., can be measured by comparing the informations about the light in relation to the image of the phase pattern at the plurality of image heights described above.

The optical characteristic of the projection optical system 15, which includes the curvature of image or the field curvature, etc., can be also measured by comparing obtained detection results at the respective image heights by detecting only the information about the light which passes through the first light-receiving pattern or the second light-receiving pattern at the plurality of image heights described above.

The astigmatism of the projection optical system 15 can be measured by comparing the information about the light in relation to the images of the phase patterns perpendicular to each other in one pattern area. In a case that the spherical aberration of the projection optical system 15 is measured, it is appropriate to use a measuring mask provided with two or more phase patterns having mutually different pitches. As described above, it is possible to measure various aberrations of the projection optical system 15 by using the method for measuring the optical characteristic of this embodiment.
In a case that the measurement is performed with different sensitivities and/or dynamic ranges of the measurement, it is also allowable to use two or more phase patterns having different directions of pattern formation and/or different pattern shapes (including, for example, pattern line widths, pattern pitches, etc.).

In the method for measuring the optical characteristic according to this embodiment, the focus deviation of the projection optical system 15 is measured by comparing the total amount I1 of the light amounts of the light received via the first light-receiving pattern 43a and the total amount I2 of the light amounts of the light received via the second light-receiving pattern 44a. However, the light amount of the light received via the first light-receiving pattern 43a (or the second light-receiving pattern 44a) may be detected at every predetermined period of time, and the time-dependent focus deviation of the projection optical system 15 may be measured from the time-dependent change amount of the total amount I1 (I2) of the light amounts of the light received via the first light-receiving pattern 43a (or the second light-receiving pattern 44a).

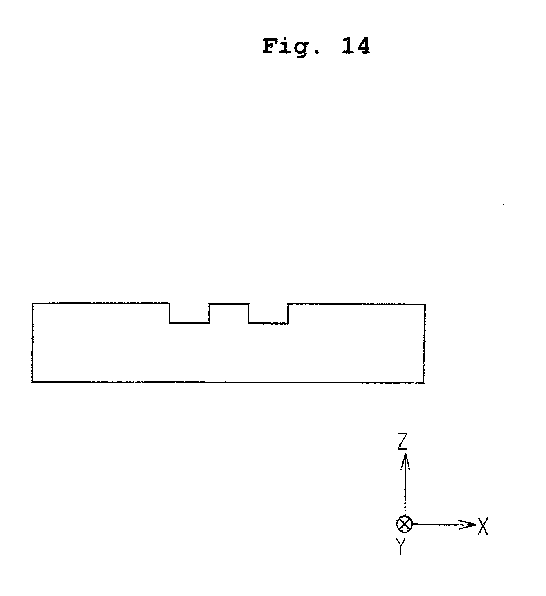

In this embodiment, the optical characteristic of the projection optical system is measured by using the phase pattern in which the recesses and the protrusions are repeatedly formed. However, the optical characteristic of the projection optical system may be measured by using about two sets of phase patterns as shown in Fig. 14.
In this embodiment, the light, which is transmitted through the recesses of the phase pattern, is received via the first light-receiving pattern, and the light, which is transmitted through the protrusions of the phase pattern, is received via the second light-receiving pattern. However, a part of the light transmitted through the recesses of the phase pattern or the light transmitted through a wide range including the recesses may be selected and received via the first light-receiving pattern, and a part of the light transmitted through the protrusions of the phase pattern or the light transmitted through a wide range including the protrusions may be selected and received via the second light-receiving pattern.
The phase difference of the phase pattern is not limited to θ = nλ/4 (n = ±1, ±3, ±5,...). However, in this embodiment, θ = nλ/2 (n = ±1, ±3, ±5,...) is excluded from the phase difference of the phase pattern.

In the embodiment described above, the light-receiving areas, which receive the light via or passing through the first light-receiving pattern 43a and the light via or passing through the second light-receiving pattern 44a, are set by the setting section in the light-receiving area of one sensor section. However, a plurality of sensor sections may be used, and the lights may be received by the sensor sections, respectively.
Further, the first light-receiving pattern for allowing the light transmitted through the recesses of the phase pattern to pass therethrough and the second light-receiving pattern for allowing the light transmitted through the protrusions of the phase pattern to pass therethrough are provided on one pattern plate. However, the first light-receiving pattern and the second light-receiving pattern may be provided distinctly on two pattern plates in a separated manner.
In the embodiment described above, in a case that the focus position of the projection optical system 15 is corrected, the wedge-shaped pair glass members are rotated relative to each other, and/or the position of the stage is controlled. In a case that the optical characteristic, which includes for example the spherical aberration and the astigmatism is corrected, the optical characteristic of the projection optical system 15 may be adjusted by performing movement of at least one of the optical members constructing the projection optical system 15 in the optical axis direction of the projection optical system 15, shift or inclination of the at least one optical member in the direction perpendicular to the optical axis of the projection optical system 15, and/or rotation of the at least one optical member about the center of the optical axis of the projection optical system 15.

In the embodiment described above, the focus position of the projection optical system 15 is simultaneously measured at the plurality of image heights in the projection area of the projection optical system 15. However, the wafer stage may be driven and controlled so as to make the measuring device, which is provided with the light-receiving pattern, be successively subjected to the scanning to arrive at positions at which two or more images of the phase pattern of the different image heights are formed, such that the focus positions at the different image heights are successively detected.

In this embodiment, the optical characteristic of the projection optical system is measured by using the transmission type phase pattern and the transmission type light-receiving pattern. However, the optical characteristic of the projection optical system may be measured by using at least one of a reflection type phase pattern and a reflection type light-receiving pattern.

This embodiment is illustrative of the exemplary case in which the light is extracted by transmitting the light through the light-receiving pattern. However, the light may be extracted such that the light is shielded by a light-receiving pattern, and the light is transmitted through or reflected by the surroundings of the light-receiving pattern.
In this embodiment, the light amount of the measuring light which passed through the reference aperture is monitored so that no influence is exerted by the change of the light amount of the illumination light. However, the reference aperture may be omitted by determining the difference ΔI in the light amount by using the expression of ΔI = (I1 - I2) / (I1 + I2).

The embodiment has been explained, which uses the spatially different light-receiving patterns to extract the light transmitted through the recesses of the phase pattern and the light transmitted through the protrusions of the phase pattern. However, a liquid crystal display device may be used as the pattern plate to electrically generate the light-receiving pattern. Of course, a shutter mechanism may be provided for the pattern plate to mechanically prepare the light-receiving pattern.

In the method for producing the projection exposure apparatus according to this embodiment, the exemplary case has been explained by way of example, in which the projection exposure apparatus is provided with the measuring device for measuring the optical characteristic of the projection optical system 15, and the optical characteristic of the projection optical system 15 is measured and adjusted after installing the projection optical system 15 in the projection exposure apparatus. However, the optical characteristic of the projection optical system 15 may be measured in accordance with the method for measuring the optical characteristic according to this embodiment and the optical characteristic may be adjusted before installing the projection optical system 15 in the projection exposure apparatus. In this case, the optical characteristic of the projection optical system 15 can be also adjusted by machining or processing (for example, repolishing) or exchanging at least one of the optical members constructing the projection optical system 15, in addition to the adjustment of the optical characteristic of the projection optical system 15 as described above.

In this embodiment, the optical characteristic of the projection optical system 15 is measured by radiating the measuring light from the object side of the projection optical system 15 and detecting the measuring light via the image plane of the projection optical system 15. However, the measuring light may be radiated from the image plane side of the projection optical system 15, and the measuring light may be detected via the object plane of the projection optical system 15. That is, the optical characteristic of the projection optical system 15 may be measured by arranging the phase pattern on the image plane side of the projection optical system 15 and arranging the light-receiving pattern on the object plane side of the projection optical system 15.
The method for measuring the optical characteristic of the projection optical system is explained in this embodiment. However, it is possible to measure the optical characteristic of an optical system of any other optical apparatus, for example, a microscope, etc.

The embodiment of the present invention is also applicable to a liquid immersion type exposure apparatus in which the liquid is intervened between the projection optical system and the wafer.
In this embodiment, the construction has been explained, in which the measuring device 20 is attached to the wafer stage 16. However, the measuring device 20 may be provided detachably with respect to the wafer stage 16.
Further, both of the wafer stage and the measuring stage may be prepared for the exposure apparatus, and the measuring device 20 may be provided on the measuring stage.

The embodiment of the present invention is also applicable to an EUV exposure apparatus which includes an illumination optical system, a projection optical system, etc. constructed of reflection type optical members, wherein the extreme ultraviolet light (EUV light) is used as the exposure light.

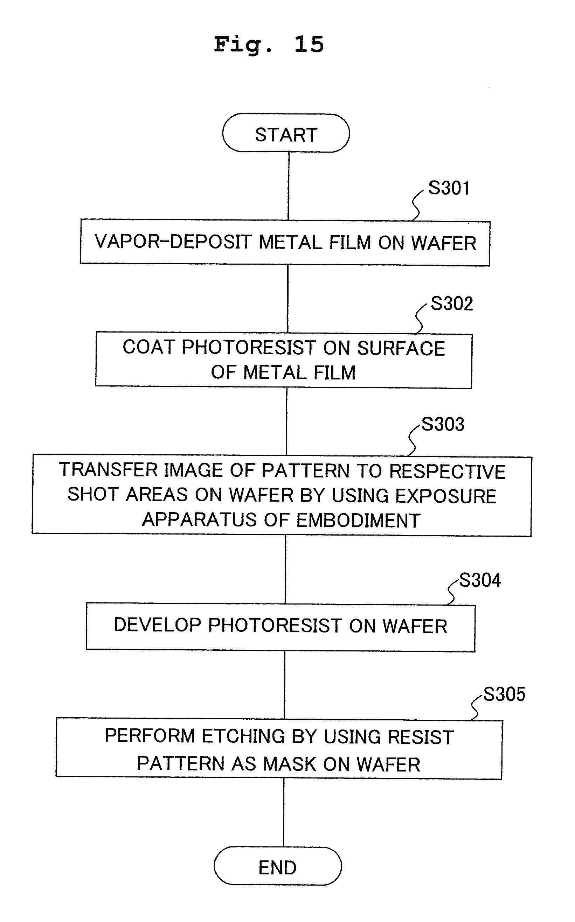

With the projection exposure apparatus according to the embodiment described above, a microdevice (a semiconductor element, an image pickup element, a liquid crystal display element, a thin film magnetic head, etc.) can be produced by exposing a photosensitive substrate (wafer W) with a transfer pattern formed by a mask M by using the projection optical system 15 (exposure step). An explanation will be made below with reference to a flow chart shown in Fig. 15 about an exemplary procedure adopted upon obtaining the semiconductor device as the microdevice by forming a predetermined circuit pattern on the wafer W, etc. as the photosensitive substrate by using the projection exposure apparatus according to the embodiment described above.

At first, in Step S301 shown in Fig. 15, a metal film is vapor-deposited on each of wafers W of 1 lot. Subsequently, in Step S302, a photoresist is coated on a surface of the metal film on each of the wafers W of 1 lot. After that, in Step S303, the pattern, which is formed on the mask M, is illuminated with the illumination light by using the projection exposure apparatus according to the embodiment described above (illuminating step). The image of the pattern illuminated with the illumination light is successively transferred to the respective shot areas on each of the wafers W of 1 lot to perform the exposure via the projection optical system 15 having the optical characteristic measured and adjusted in accordance with the optical characteristic measuring method and the optical characteristic adjusting method according to this embodiment (exposure step). After that, the photoresist on each of the wafers W of 1 lot is developed in Step S304, and then the etching is performed by using the resist pattern as a mask on each of the wafers W of 1 lot in Step S305. Accordingly, the circuit pattern, which corresponds to the pattern of the mask M, is formed on each of the shot areas on each of the wafers W.

After that, for example, circuit patterns of upper layers are formed, and thus the device such as the semiconductor element or the like is produced. According to the exposure method concerning this embodiment, the exposure is performed by using the projection optical system 15 adjusted in accordance with the method for adjusting the optical characteristic concerning this embodiment. Therefore, the image of the pattern of the mask M can be formed at a high resolution on the wafer W. In Step S301 to Step S305, the metal is vapor-deposited on the wafer W, and the surface of the metal film is coated with the resist to perform the respective steps of the exposure, the development, and the etching. However, it goes without saying that a silicon oxide film may be formed on the wafer W prior to these steps, and then the surface of the silicon oxide film may be coated with the resist to perform the respective steps of the exposure, the development, the etching, etc.
The present invention relates to the theme or the subject included in Japanese Patent Application No. 2007-168021 filed on June 26, 2007, the entire disclosure of which is evidently incorporated herein by reference.

### INDUSTRIAL APPLICABILITY

The optical characteristic adjusting method of the present invention is useful to measure the optical characteristic of the optical system usable to produce the electronic device such as the semiconductor element, the liquid crystal display element or the like in the lithography step. The optical characteristic of the optical system can be adjusted highly accurately by using the exposure apparatus provided with the optical system adjusted in accordance with the optical characteristic adjusting method of the present invention and the exposure method using the exposure apparatus. The exposure apparatus, which is provided with the optical system having the satisfactory optical characteristic, can be produced in accordance with the exposure apparatus producing method for producing the exposure apparatus.

## Claims

1. An optical characteristic measuring method for measuring an optical characteristic of an optical system which forms, on a second plane, an image of an object arranged on a first plane, the optical characteristic measuring method **characterized by** comprising:
an arranging step of arranging at least one phase pattern on the first plane;
an illuminating step of illuminating the phase pattern, arranged in the arranging step, with a light having a predetermined wavelength;
an extracting step of extracting a partial image of a pattern image formed via the phase pattern and the optical system; and
a detecting step of detecting information about the light in relation to the partial image extracted in the extracting step.

2. The optical characteristic measuring method according to claim 1, **characterized in that** a phase difference θ of the phase pattern is expressed as follows provided that λ represents the predetermined wavelength:
θ = nλ/4 (n = ±1, ±3, ±5,...).

3. The optical characteristic measuring method according to claim 1 or 2, **characterized in that** the partial image is extracted in the extracting step by using a light-receiving pattern arranged on the second plane.

4. The optical characteristic measuring method according to any one of claims 1 to 3, **characterized in that** the pattern image has an intensity distribution having a first intensity corresponding to an area in which a phase of the phase pattern is relatively advanced and a second intensity corresponding to an area in which the phase of the phase pattern is relatively delayed;
a part of the image, which has the first intensity, is extracted as the partial image from the pattern image in the extracting step; and
first information about the light in relation to the partial image is detected in the detecting step.

5. The optical characteristic measuring method according to claim 4, **characterized by** comprising a measuring step of measuring the optical characteristic based on the first information.

6. The optical characteristic measuring method according to any one of claims 1 to 3, **characterized in that** the pattern image has an intensity distribution having a first intensity corresponding to an area in which a phase of the phase pattern is relatively advanced and a second intensity corresponding to an area in which the phase of the phase pattern is relatively delayed;
a part of the image, which has the second intensity, is extracted as the partial image from the pattern image in the extracting step; and
second information about the light in relation to the partial image is detected in the detecting step.

7. The optical characteristic measuring method according to claim 6, **characterized by** comprising a measuring step of measuring the optical characteristic based on the second information.

8. The optical characteristic measuring method according to any one of claims 1 to 3, **characterized in that** the pattern image has an intensity distribution having a first intensity corresponding to an area in which a phase of the phase pattern is relatively advanced and a second intensity corresponding to an area in which the phase of the phase pattern is relatively delayed;
a part of the image which has the first intensity is selectively extracted as the partial image from the pattern image and a part of the image which has the second intensity is selectively extracted as the partial image from the pattern image in the extracting step; and
first information about the light in relation to the part of the image having the first intensity and second information about the light in relation to the part of the image having the second intensity are detected in the detecting step.

9. The optical characteristic measuring method according to claim 8, **characterized by** comprising a measuring step of measuring the optical characteristic of the optical system by comparing the first information and the second information.

10. The optical characteristic measuring method according to any one of claims 1 to 9, **characterized in that** two or more pieces of the phase pattern are arranged in the first plane in the arranging step.

11. The optical characteristic measuring method according to claim 10, **characterized in that** the two or more pieces of the phase pattern include patterns of mutually different types.

12. The optical characteristic measuring method according to any one of claims 1 to 11, **characterized in that** the optical characteristic is an aberration which is symmetrical with respect to an optical axis of the optical system in relation to a measuring direction of the optical characteristic.

13. An optical characteristic adjusting method
**characterized by** comprising:
a measuring step of measuring an optical characteristic of an optical system in accordance with the optical characteristic measuring method as defined in any one of claims 1 to 12; and
an adjusting step of adjusting the optical characteristic of the optical system by using a measurement result obtained in the measuring step.

14. The optical characteristic adjusting method according to claim 13, **characterized in that** the optical characteristic is adjusted in the adjusting step by machining or exchanging at least one optical member constructing the optical system.

15. The optical characteristic adjusting method according to claim 13, **characterized in that** the optical characteristic is adjusted in the adjusting step by performing at least one of movement of at least one optical member constructing the optical system in an optical axis direction of the optical system, shift or inclination of the at least one optical member in a direction perpendicular to the optical axis direction, and rotation of the at least one optical member about a center of an optical axis of the optical system.

16. An exposure apparatus which forms a pattern of a mask on a photosensitive substrate, the exposure apparatus **characterized by** comprising an optical system which is adjusted in accordance with the optical characteristic adjusting method as defined in any one of claims 13 to 15.

17. An exposure apparatus which forms a pattern of a mask via an optical system on a photosensitive substrate, the exposure apparatus **characterized by** comprising:
an extracting section which extracts an image of a part of a pattern image formed via the optical system and a phase pattern arranged on one of an object plane and an image plane of the optical system; and
a detecting section which detects information about a light in relation to the image of the part extracted by the extracting section.

18. The exposure apparatus according to claim 17, **characterized in that** the pattern image has an intensity distribution having a first intensity corresponding to an area in which a phase of the phase pattern is relatively advanced and a second intensity corresponding to an area in which the phase of the phase pattern is relatively delayed; and
the extracting section extracts, as the image of the part, at least one of a part of the image having the first intensity and a part of the image having the second intensity from the pattern image.

19. The exposure apparatus according to claim 17 or 18, **characterized by** comprising:
a substrate stage which holds the photosensitive substrate; and
a controller which controls a position of the substrate stage based on the information about the light detected by the detecting section.

20. An exposure method for forming a pattern of a mask on a photosensitive substrate, the exposure method **characterized by** comprising:
an illuminating step of illuminating the pattern; and
an exposure step of forming an image of the pattern, illuminated in the illuminating step, on the photosensitive substrate by an optical system adjusted in accordance with the optical characteristic adjusting method as defined in any one of claims 13 to 15.

21. An exposure apparatus producing method for producing an exposure apparatus which forms a pattern of a mask via an optical system on a photosensitive substrate, the exposure apparatus producing method **characterized by** comprising:
an adjusting step of adjusting an optical characteristic of the optical system in accordance with the optical characteristic adjusting method as defined in any one of claims 13 to 15; and
an installing step of installing, in the exposure apparatus, the optical system adjusted in the adjusting step.

22. An exposure apparatus producing method for producing an exposure apparatus which forms a pattern of a mask via an optical system on a photosensitive substrate, the exposure apparatus producing method **characterized by** comprising:
an installing step of installing the optical system in the exposure apparatus; and
an adjusting step of adjusting an optical characteristic of the optical system, installed in the installing step, in accordance with the optical characteristic adjusting method as defined in any one of claims 13 to 15.
